# EUROPEAN PATENT APPLICATION

(11) **EP 4 746 677 A1**
(43) Date of publication of application: **20.05.2026**
(21) Application number: 25207595.7
(22) Date of filing: 08.10.2025
(51) Int. Cl.: H10W 70/654, H10W 70/60, H10W 70/63, H10W 90/00

(54) **INTEGRATED CIRCUIT PACKAGES INCLUDING A SURFACE REDISTRIBUTED INTERCONNECT BRIDGE FOR DIE-TO-DIE INTERCONNECTS**

(30) Priority: 14.11.2024 US 202418947505
(71) Applicant: INTEL Corporation, Santa Clara, CA 95054 (US)
(72) Inventor: CHEAH, Bok Eng, 11700 Penang (MY); ONG, Jenny Shio Yin, 11900 Bayan Lepas 07 (MY); LIM, Seok Ling, 14000 Penang (MY); KONG, Jackson Chung Peng, 10470 Penang (MY); OOI, Kooi Chi, 11700 Bukit Gambir (MY); WONG, Shaw Fong, 12300 Penang (MY); KUAN, Chin Lee, 28700 Bentong (MY); POH, Yang Liang, 14000 Penang (MY)
(74) Representative: HGF

(57) **Abstract**

Microelectronic assemblies, related devices and methods, are disclosed herein. In some embodiments, a microelectronic assembly may include a core including conductive vias extending between a first surface and an opposing second surface of the core, the second surface of the core is planar; a substrate on the second surface of the core, the substrate including a third surface and an opposing fourth surface, the third surface of the substrate is in contact with the second surface of the core, and the fourth surface of the substrate includes conductive contacts; and a die at the second surface of the core, partially overlapping the substrate, including first conductive contacts electrically coupled to some of the conductive contacts of the substrate and second conductive contacts electrically coupled to some of the conductive vias in the core. In some embodiments, a thickness of the substrate is between 10 microns and 50 microns.

## Description

### Background

For the past several decades, scaling of features in integrated circuits (ICs) has been a driving force behind an ever-growing semiconductor industry and emerging applications in fields such as big data, artificial intelligence, mobile communications, and autonomous driving. Scaling to smaller and smaller features enables increased densities of functional units on the limited real estate of semiconductor chips. For example, shrinking transistor size allows incorporation of an increased number of memory or logic devices on a chip, lending to the fabrication of products with increased capacity. The drive for the ever-increasing capacity, however, is not without issue. The necessity to optimize fabrication and performance of each component (e.g., of each transistor) is becoming increasingly significant.

Parallel to optimizations at the transistor level, advanced IC packaging landscape is rapidly evolving to accommodate performance expectations and requirements of shrinking transistor size. Multiple IC dies are now commonly coupled together in a multi-die IC package to integrate features or functionality and to facilitate connections to other components, such as package substrates. For example, IC packages may include an embedded multi-die interconnect bridge (EMIB) for coupling two or more IC dies.

Integration of multiple dies in a single IC package has tremendous benefits but adds additional complexities due to placing materials with different material properties in close proximity to one another. When an IC package undergoes multiple processing steps involving various temperatures and pressure loads, individual materials within the package may behave differently from one another, resulting in out of plane deformation of various layers, known as "package warpage." One way to address package warpage is to use stiffer cores to which different IC dies are attached. Recently, glass cores have been explored as alternatives to organic resin-based cores (e.g., cores based on using Ajinomoto Build-up Film (ABF)). Glass is considered more rigid than organic resin-based materials and has several advantages such as excellent thermal properties, low coefficient of thermal expansion (CTE), high electrical insulation, chemical resistance, optical transparency, and compatibility with advances semiconductor properties. However, a major challenge for widespread adoption of glass cores is the fact that glass is highly susceptible to damage due to mechanical and/or thermal stresses.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a schematic side, cross-sectional view of an example microelectronic assembly according to some embodiments of the present disclosure.
FIG. 2 is a schematic top view of an example microelectronic assembly according to some embodiments of the present disclosure.
FIG. 3 is a schematic side, cross-sectional view of another example microelectronic assembly according to some embodiments of the present disclosure.
FIG. 4 is a schematic side, cross-sectional view of yet another example microelectronic assembly according to some embodiments of the present disclosure.
FIGS. 5A-5H are simplified side, cross-sectional views illustrating various manufacturing steps of an example microelectronic assembly according to some embodiments of the present disclosure.
FIGS. 6A-6D are simplified side, cross-sectional views illustrating various manufacturing steps of another example microelectronic assembly according to some embodiments of the present disclosure.
FIG. 7 is a cross-sectional view of a device package that may include one or more microelectronic assemblies in accordance with any of the embodiments disclosed herein.
FIG. 8 is a cross-sectional side view of a device assembly that may include one or more microelectronic assemblies in accordance with any of the embodiments disclosed herein.
FIG. 9 is a block diagram of an example computing device that may include one or more microelectronic assemblies in accordance with any of the embodiments disclosed herein.

### Detailed Description

Communicating large numbers of signals between two or more dies in a multi-die IC package is challenging due to the increasingly small size of such dies and increased use of stacking dies. Multi-die IC packaging typically requires increased die segregation, additional power delivery requirements, and stricter routing and alignment tolerances throughout the package. The greater number of embedded dies and smaller size of embedded dies (i.e., dies, passives, etc.) vastly increases manufacturing complexity as well as routing complexity. For example, a multi-die IC package may include encapsulated bridge dies (e.g., dies embedded within a substrate, such as EMIBs) and top dies (e.g., dies coupled to the embedded die at a surface of the substrate). A multi-die IC package may include a core, such as a "glass layer," with through-glass vias (TGVs) extending through the core for front-to-back connections between two different substrates. A substrate may include a dielectric material with conductive pathways therein that are typically formed on a surface of the core. The conductive pathways through the dielectric material may provide routing for design flexibility, and the uniform diameters of the TGVs may provide dimensional stability and improved connectivity.

Typically, a multi-die IC package includes a cavity formed in the substrate on a core and the bridge die is at least partially embedded within the cavity and surrounded by a dielectric material, such as a buildup material, or a mold material, such as an epoxy-based resin with fillers. A bridge die may be electrically coupled to conductive contacts at a bottom surface of the cavity by solder bumps. Such interconnects typically utilize a non-conductive film (NCF) at a bottom surface of the bridge die to function as an underfill material that flows around and between the solder bumps and subsequently cures. An NCF material generally includes inorganic fillers to improve the mechanical and reliability properties of the material, however, these inorganic fillers are often trapped at the solder to conductive contact interface during the bonding and solder reflow process, which prevents the solder bumps from forming interconnects and is likely to create malfunctions, failures, and other reliability issues in multi-die IC packages during use. Further, the use of an NCF material requires a surface finish material, such as gold, on the conductive contacts, is volatile (e.g., has a short pot life between lamination on the bottom surface of the bridge die to solder bump bonding), which limits manufacturing timeframes, and involves a complicated prep process to lamination bridge dies at the wafer level and to, subsequently, singulate.

Various ones of the embodiments disclosed herein may help reduce the cost and complexity associated with assembling multi-die IC packages relative to conventional approaches by incorporating an interconnect bridge on a portion of a surface of a core, which decreases warpage from CTE material mismatch, reduces an overall thickness (e.g., z-height) of an IC package, improves electrical performance by minimizing signal impedance discontinuity and signal distortion, lowers IC package cost of production, and enables design flexibility by allowing non-orthogonal routing of conductive pathways.

Accordingly, microelectronic assemblies, related devices and methods, are disclosed herein. Microelectronic assemblies, related devices and methods, are disclosed herein. In some embodiments, a microelectronic assembly may include a core including conductive vias extending between a first surface and an opposing second surface of the core, the second surface of the core is planar; a substrate on the second surface of the core, the substrate including a third surface and an opposing fourth surface, the third surface of the substrate is in contact with the second surface of the core, and the fourth surface of the substrate includes conductive contacts; and a die at the second surface of the core, partially overlapping the substrate, including first conductive contacts electrically coupled to some of the conductive contacts of the substrate and second conductive contacts electrically coupled to some of the conductive vias in the core. In some embodiments, a thickness of the substrate is between 10 microns and 50 microns.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are stated in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may include substantially monocrystalline semiconductors, such as silicon or germanium, as a base material on which integrated circuits are fabricated with traditional semiconductor processing methods. The semiconductor base material may include, for example, N-type or P-type materials. Dies may include, for example, a crystalline base material formed using a bulk silicon (or other bulk semiconductor material) or a semiconductor-on-insulator (SOI, e.g., a silicon-on-insulator) structure. In some other embodiments, the base material of one or more of the IC dies may include alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may include compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may include an intrinsic IV or III-V semiconductor material or alloy, not intentionally doped with any electrically active impurity; in alternate embodiments, nominal impurity dopant levels may be present. In still other embodiments, dies may include a non-crystalline material, such as polymers; for example, the base material may include silica-filled epoxy. In other embodiments, the base material may include high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of input/output (I/O) functions, arithmetic operations, pipelining of data, etc.).

In another example, the terms "package" and "IC package" are synonymous, as are the terms "die" and "IC die." Note that the terms "chip," "chiplet," "die," and "IC die" are used interchangeably herein.

The term "optical structure" includes arrangements of forms fabricated in ICs to receive, transform and/or transmit optical signals as described herein. It may include optical conductors such as waveguides, electromagnetic radiation sources such as lasers and light-emitting diodes (LEDs) and electro-optical devices such as photodetectors.

In various embodiments, any photonic IC (PIC) described herein may include a semiconductor material, for example, N-type or P-type materials. The PIC may include, for example, a crystalline base material formed using a bulk silicon (or other bulk semiconductor material) or a SOI structure (or, in general, a semiconductor-on-insulator structure). In some embodiments, the PIC may be formed using alternative materials, which may or may not be combined with silicon, that include, but are not limited to, lithium niobite, indium phosphide, silicon dioxide, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-N or group IV materials. In some embodiments, the PIC may include a non-crystalline material, such as polymers. In some embodiments, the PIC may be formed on a printed circuit board. In some embodiments, the PIC may be inhomogeneous, including a carrier material (such as glass or silicon carbide) as a base material with a thin semiconductor layer over which is an active side comprising transistors and like components. Although a few examples of the material for the PIC are described here, any material or structure that may serve as a foundation upon which the PIC may be built falls within the spirit and scope of the present disclosure.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., metal oxide semiconductor (MOS) FETs (MOSFETs). In general, a FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are included in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a PIC, "interconnect" may also describe any element formed of a material that is optically conductive for providing optical connectivity to one or more elements associated with the PIC. In such cases, the term "interconnect" may refer to optical waveguides (e.g., structures that guide and confine light waves), including optical fiber, optical splitters, optical combiners, optical couplers, and optical vias.

The term "waveguide" refers to any structure that acts to guide the propagation of light from one location to another location typically through a substrate material such as silicon or glass. In various examples, waveguides can be formed from silicon, doped silicon, silicon nitride, glasses such as silica (e.g., silicon dioxide or SiO2), borosilicate (e.g., 70-80 wt% SiO2, 7-13 wt% of B2O3, 4-8 wt% Na2O or K2O, and 2-8 wt% of Al2O3) and so forth. Waveguides may be formed using various techniques including but not limited to forming waveguides in situ. For example, in some embodiments, waveguides may be formed in situ in glass using low temperature glass-to-glass bonding or by laser direct writing. Waveguides formed in situ may have lower loss characteristics.

The term "conductive trace" may be used to describe an electrically conductive element isolated by an insulating material. Within IC dies, such insulating material includes interlayer low-k dielectric that is provided within the IC die. Within package substrates, and printed circuit boards (PCBs) such insulating material includes organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

In context of a stack of dies coupled to one another or in context of a die coupled to a package substate, the term "interconnect" may also refer to, respectively, die-to-die (DTD) interconnects and die-to-package substrate (DTPS) interconnects. DTD interconnects may also be referred to as first-level interconnects (FLI). DTPS interconnects may also be referred to as Second-Level Interconnects (SLI). Although not specifically shown in all of the present illustrations in order to not clutter the drawings, when DTD or DTPS interconnects are described, a surface of a first die may include a first set of conductive contacts, and a surface of a second die or a package substrate may include a second set of conductive contacts. One or more conductive contacts of the first set may then be electrically and mechanically coupled to some of the conductive contacts of the second set by the DTD or DTPS interconnects. In some embodiments, the pitch of the DTD interconnects may be different from the pitch of the DTPS interconnects, although, in other embodiments, these pitches may be substantially the same.

It will be recognized that one more levels of underfill (e.g., organic polymer material such as benzotriazole, imidazole, polyimide, or epoxy) may be provided in an IC package described herein and may not be labeled in order to avoid cluttering the drawings. In various embodiments, the levels of underfill may include the same or different insulating materials. In some embodiments, the levels of underfill may include thermoset epoxies with silicon oxide particles; in some embodiments, the levels of underfill may include any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, glass transition temperature, viscosity and chemical resistance, among other factors; in some embodiments, the choice of underfill material may be based on both design and processing considerations.

In some embodiments, one or more levels of solder resist (e.g., epoxy liquid, liquid photoimageable dielectrics, dry film photoimageable dielectrics, acrylics, solvents) may be provided in an IC package described herein and may not be labeled or shown to avoid cluttering the drawings. Solder resist may be a liquid or dry film material including photoimageable dieletrics. In some embodiments, solder resist may be non-photoimageable.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/- 5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

Coordinates, when included in the accompanying drawings, identify a thickness or a height by z-dimension, a width by y-dimension, and a length by x-dimension. A diameter or cross section may be identified by xy-dimension.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images, average grain size of a material may be determined. Also, in such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

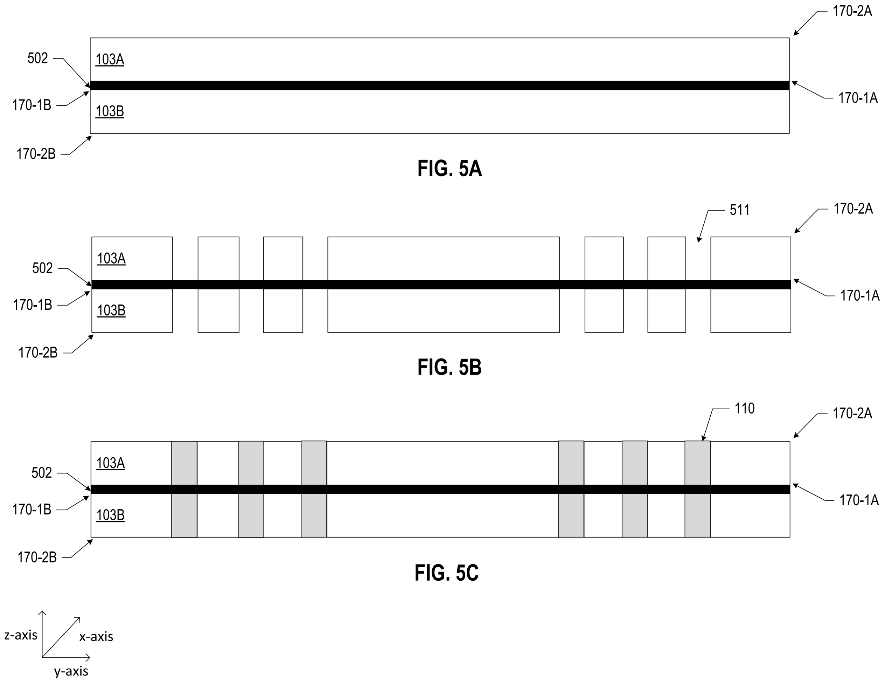

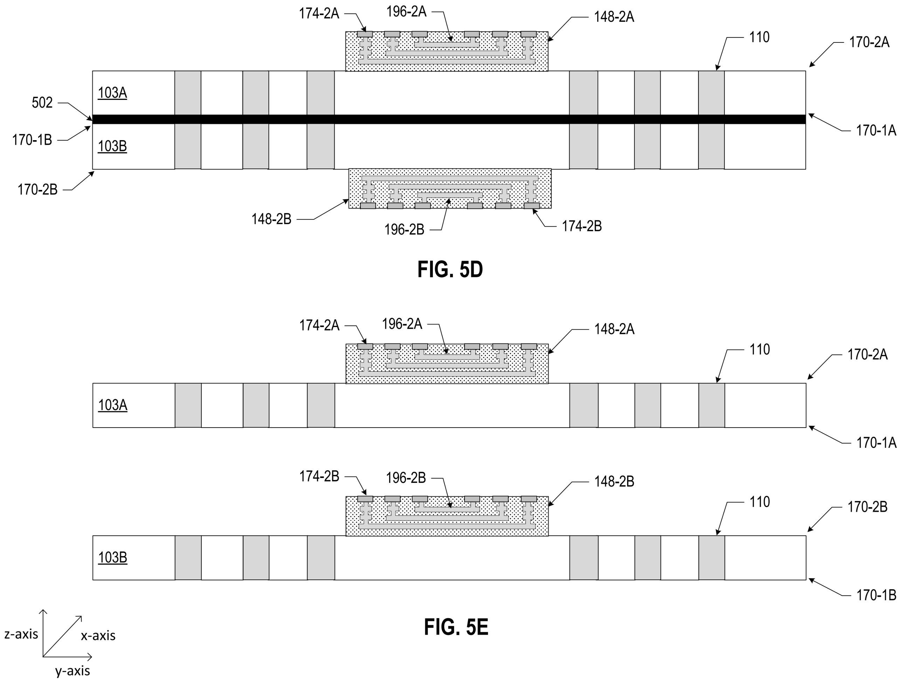

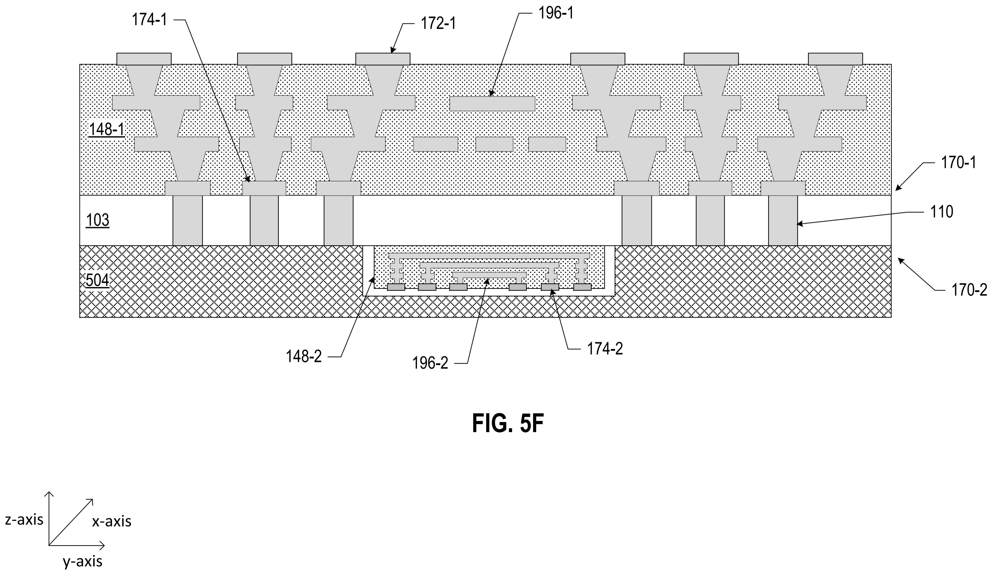

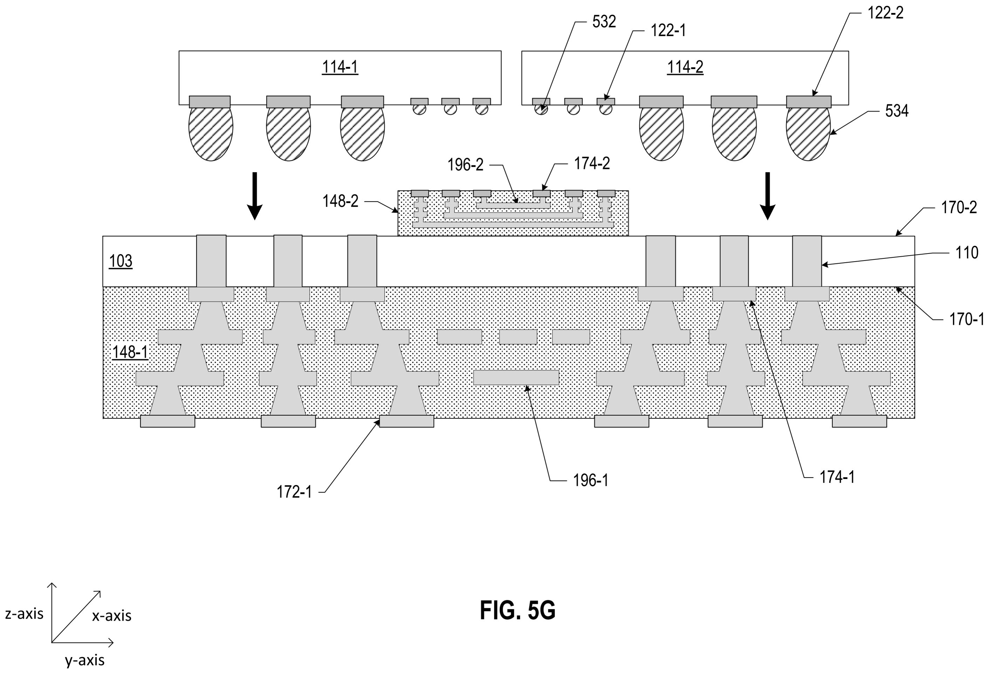

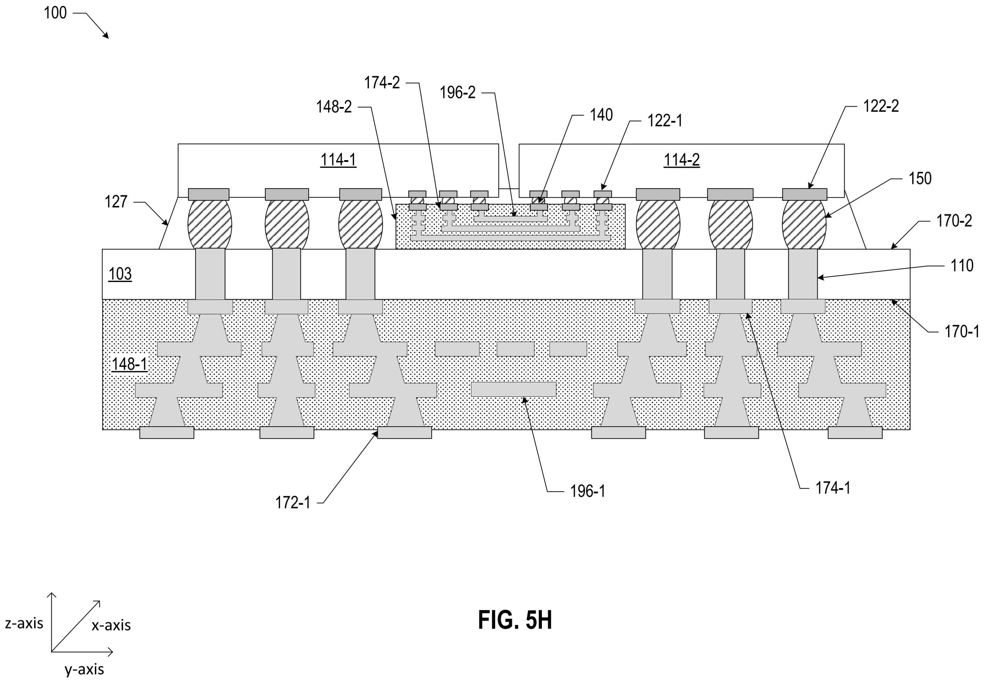

For convenience, if a collection of drawings designated with different letters are present (e.g., FIGS. 5A-5H), such a collection may be referred to herein without the letters (e.g., as "FIG. 5"). Similarly, if a collection of reference numerals designated with different numbers and/or letters are present (e.g., 114-1, 114-2), such a collection may be referred to herein without the numbers (e.g., as "114").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

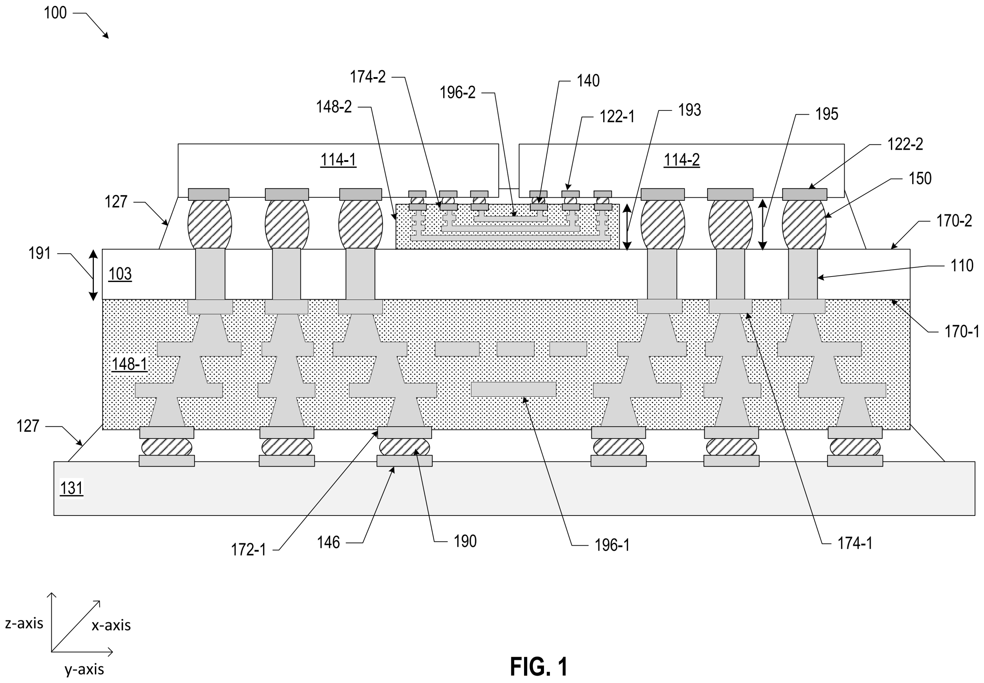

FIG. 1 is a schematic cross-sectional view of an example microelectronic assembly 100, according to some embodiments of the present disclosure. Microelectronic assembly 100 may include a core 103 having a first substrate 148-1 on a first surface 170-1 of the core 103, a second substrate 148-2 on a second surface 170-2 of the core 103 that is opposite the first surface 170-1, and TGVs 110 extending between the first surface 170-1 and the second surface 170-2 of the core 103.

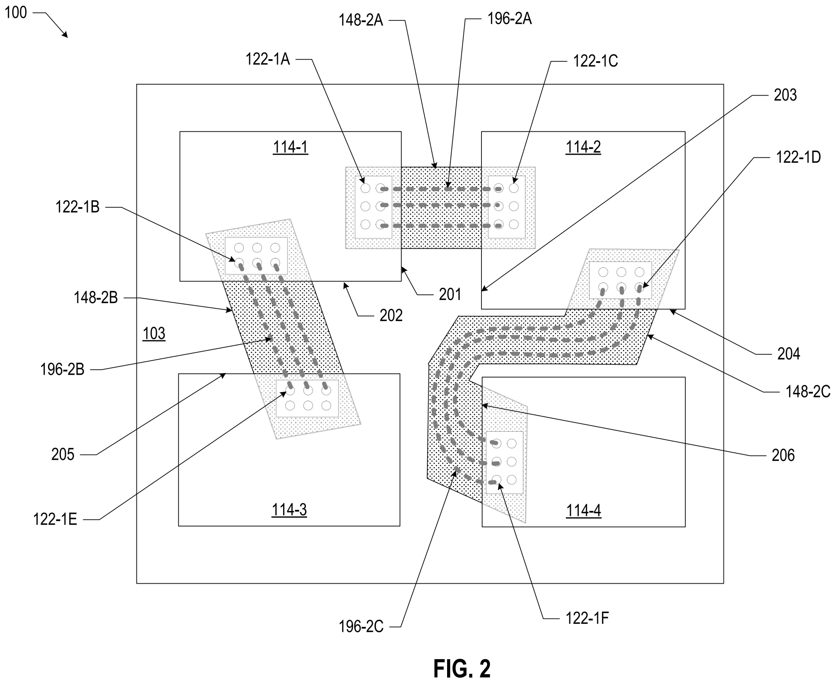

The second substrate 148-2 may also be referred to herein as a "surface redistributed interconnect bridge" (SRIB). The SRIB 148-2 may include conductive pathways 196-2 (e.g., including conductive traces and/or conductive vias, as shown) through a dielectric material. The SRIB 148-2 may include a set of conductive contacts 174-2 at the top surface of the SRIB 148-2, where the conductive pathways 196-2 electrically couple individual ones of the conductive contacts 174-2 to other individual ones of the conductive contacts 174-2. The SRIB 148-2 may be on (e.g., in contact with or directly physically contacting) part of the second surface 170-2 of the core 103 (e.g., on only a portion), where the second surface 170-2 of the core has a first surface area (e.g., xy-dimension) and the SRIB 148-2 has a second surface area (e.g., xy-dimension or a composite xy-dimension) and the second surface area is smaller than the first surface area, as described in more detail below with reference to FIG. 2. A thickness 193 (e.g., z-dimension) of the SRIB 148-2 may be between 10 microns and 50 microns. An SRIB 148-2 may be manufactured using any suitable technique, such as a photolithography process. A photolithography process may include electroplating, UV exposure, chemical etching, lamination, or laser etching/drilling process. In some embodiments, a dielectric material of the SRIB 148-2 may include an organic dielectric, for example, a bismaleimide triazine (BT) resin, a polyimide material, an epoxy material (e.g., a glass reinforced epoxy matrix material, an epoxy build-up film, or the like), a mold material, a ceramic dielectric, a silicon-based dielectric (e.g., silicon dioxide or silicon nitride), a silicone rubber, polytetrafluoroethylene (PTFE), an oxide-based material (e.g., spin on oxide), or low-k and ultra low-k dielectric (e.g., a carbon-doped dielectric, a fluorine-doped dielectric, a porous dielectric, and an organic polymeric dielectric). In some embodiments, the conductive pathways 196-2 have non-Manhattan routing (e.g., as shown in FIG. 2). Non-Manhattan routing refers to the use of curvilinear or diagonal conductive pathways instead of traditional orthogonal (e.g., right-angled) Manhattan routing. Non-Manhattan routing may allow for more complex and efficient interconnect patterning, which may reduce resistance and may improve signal integrity. In some embodiments, the second conductive pathways 196-2 have a line width/spacing between 1µm/1µm and 5µm/5µm. As used herein, a line width/spacing of 1µm/1µm refers to a 1 micron line width to a 1 micron spacing between a line and an adjacent line.

The first substrate 148-1 may include conductive pathways 196-1 (e.g., including conductive traces and/or conductive vias, as shown) through a dielectric material. The first substrate 148-1 may include a set of first conductive contacts 172-1 at the bottom surface of the first substrate 148-1 and a set of second conductive contacts 174-1 at the top surface of the first substrate 148-1, where the conductive pathways 196-1 electrically couple individual ones of the first and second conductive contacts 172-1, 174-1. In some embodiments, the first conductive pathways 196-1 have a line width/spacing between 9µm/12µm and 14µm/20µm. In some embodiments, the first conductive pathways 196-1 have a line width/spacing between 14µm/20µm and 20µm/50µm. In some embodiments, conductive contacts 174-1 at the first surface 170-1 of the core 103 may be omitted. The first substrate 148-1 may be manufactured using any suitable technique, such as a semi-additive process, a subtractive etching technique, or other conventional substrate package techniques. In some embodiments, a dielectric material of the first substrate 148-1 may include a bismaleimide triazine (BT) resin, a polyimide material, an epoxy material (e.g., a glass reinforced epoxy matrix material, an epoxy build-up film, or the like), a mold material, a ceramic dielectric, a silicon-based dielectric (e.g., silicon dioxide or silicon nitride), a silicone rubber, polytetrafluoroethylene (PTFE), an oxide-based material (e.g., spin on oxide), or low-k and ultra low-k dielectric (e.g., a carbon-doped dielectric, a fluorine-doped dielectric, a porous dielectric, and an organic polymeric dielectric).

A core 103 may have any suitable size, shape, and material for providing mechanical support to a microelectronic assembly 100. A core 103 may have an overall thickness 191 (e.g., z-dimension or z-height) between 50 microns and 700 microns (i.e., between 100 microns and 200 microns). In some embodiments, a material of the core 103 may include silicon, an organic dielectric, or a ceramic. In some embodiments, a material of the core 103 may include glass, such as bulk transparent glass, and also may be referred to herein as a "glass core" or a "glass layer." As used herein, the term "glass core" refers to a structure (e.g., a portion of a glass layer) of any glass material such as quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass. In particular, a material of a core 103 may include a bulk glass or a solid volume/layer of glass, as opposed to, e.g., materials that may include particles of glass, such as glass fiber reinforced polymers. Such glass materials are typically non-crystalline, often transparent, amorphous solids. In some embodiments, the core 103 may be an amorphous solid glass layer. In some embodiments, the core 103 may include silicon and oxygen, as well as any one or more of aluminum, boron, magnesium, calcium, barium, tin, sodium, potassium, strontium, phosphorus, zirconium, lithium, titanium, and zinc. In some embodiments, the core 103 may include a material, e.g., any of the materials described above, with a weight percentage of silicon being at least about 0.5%, e.g., between about 0.5% and 50%, between about 1% and 48%, or at least about 23%. For example, if the core 103 is fused silica, the weight percentage of silicon may be about 47%. In some embodiments, the core 103 may include at least 23% silicon and/or at least 26% oxygen by weight, and, in some further embodiments, the core 103 may further include at least 5% aluminum by weight. In some embodiments, the core 103 may include any of the materials described above and may further include one or more additives such as Al₂O₃, B₂O₃, MgO, CaO, SrO, BaO, SnO₂, Na₂O, K₂O, SrO, P₂O₃, ZrO₂, Li₂O, Ti, and Zn. In some embodiments, the core 103 may be a layer of glass that does not include an organic adhesive or an organic material. The core 103 may be distinguished from, for example, the "prepreg" or "RF4" core of a PCB substrate which typically includes glass fibers embedded in a resinous organic material such as an epoxy. In some embodiments, a cross-section of the core 103 in an xz plane, an yz plane, and/or an xy plane of an example coordinate system, shown in FIG. 1, may be substantially rectangular.

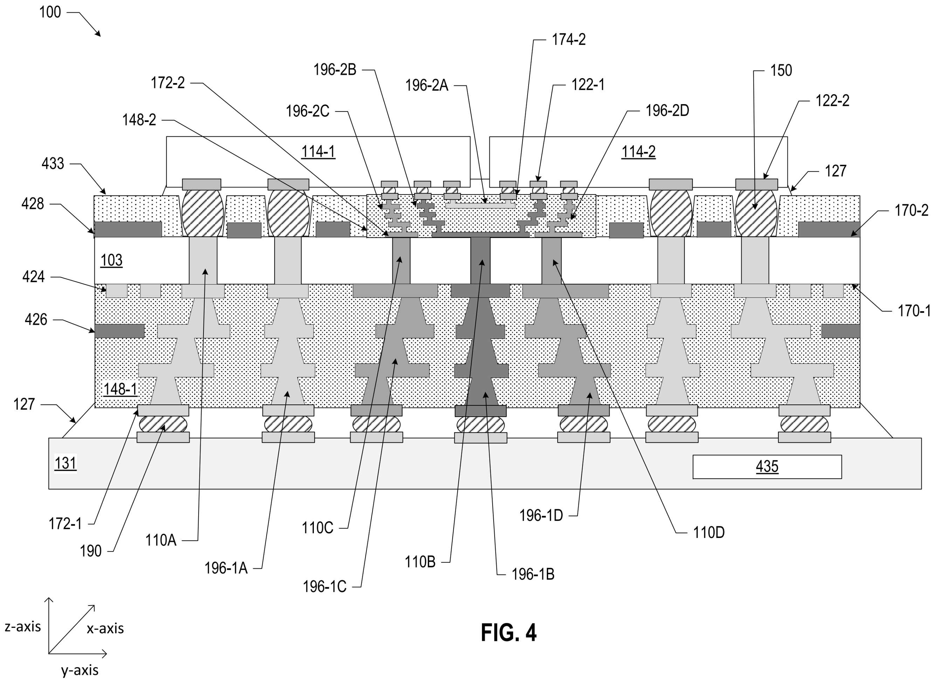

TGVs 110 may have any suitable size and shape. A thickness (e.g., z-dimension) of the individual TGVs 110 may be between 50 microns and 700 microns (i.e., between 100 microns and 200 microns). A diameter (e.g., xy-dimension) of the individual TGVs 110 may be between 5 microns and 100 microns (e.g., between 20 microns and 50 microns). In some embodiments, TGVs 110 have an aspect ratio between 5:1 and 30:1. An aspect ratio of a TGV 110 is the ratio of an overall thickness 191 (e.g., z-dimension or z-height) of the TGV to a diameter (e.g., xy-dimension) of the TGV, for example, a TGV having a thickness of 200 microns and a diameter of 20 microns has an aspect ratio equal to 10:1. TGVs 110 are shown in FIG. 1 as having straight sides; however, in various embodiments, the TGVs 110 may have sides that taper toward a middle (e.g., have an hourglass shape), may have sides that taper toward a first surface 170-1 or a second surface 170-2 (e.g., have a V-shape), and/or may have other irregularities depending on the processing conditions for generating TGVs 110. TGVs 110 may be formed using any suitable process, including, for example, via openings may be formed by laser activation and wet etch, laser ablation, or laser drilling, and a conductive material may be deposited in the via openings. TGVs 110 may be formed of any suitable conductive material, such as copper, silver, tin-silver, nickel, gold, aluminum, or other metals or alloys. In some embodiments, a pitch of the TGVs 110 may be between 25 microns and 200 microns (e.g., between 75 microns and 150 microns). The TGVs 110 in the core 103 may electrically couple the first substrate 148-1 and dies 114-1, 114-2. In some embodiments, the TGVs 110 in the core 103 may electrically couple the first substrate 148-1 and the SRIB 148-2 (e.g., as shown in FIG. 4). TGVs 110 in core 103 may enable power, ground and signal connectivity to components located on either side of the core 103, for example, between dies 114-1, 114-2 and a circuit board 131.

The microelectronic assembly 100 may further include die 114-1 and die 114-2 electrically coupled to a top surface of the SRIB 148-2 by interconnects 140 (e.g., DTD interconnects). In particular, conductive contacts 122-1 on a bottom surface of die 114-1, 114-2 may be electrically and mechanically coupled to conductive contacts 174-2 at a top surface of the SRIB 148-2 by interconnects 140. Interconnects 140 may enable electrical coupling between die 114-1 and die 114-2 through conductive pathways 196-2 in SRIB 148-2. Interconnects 140 disclosed herein may take any suitable form. In some embodiments, a set of interconnects 140 may include solder (e.g., solder bumps or balls that are subject to a thermal reflow to form the interconnects 140). Interconnects 140 that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of interconnects 140 may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film (e.g., a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression. In some embodiments, interconnects 140 disclosed herein may have a pitch between about 10 microns and 50 microns.

The microelectronic assembly 100 may further include die 114-1 and die 114-2 electrically coupled to the second surface 170-2 of the core 103 by glass core-to-die (GCTD) interconnects 150. In particular, conductive contacts 122-2 on a bottom surface of die 114-1, 114-2 may be electrically and mechanically coupled to TGVs 110 in the core 103 by interconnects 150. Interconnects 150 may enable electrical coupling of die 114-1 and die 114-2 to circuit board 131 through conductive pathways 196-1 in the first substrate 148-1. Interconnects 150 disclosed herein may take any suitable form, including any of the forms described above with reference to interconnects 140, such as solder (e.g., solder bumps or balls that are subject to a thermal reflow to form the interconnects 150). In some embodiments, interconnects 150 may include conductive contacts on the second surface 170-2 of the core 103 electrically coupled to TGVs 110 (not shown). A height 195 (e.g., z-dimension) of the interconnects 150 is greater than a thickness 193 (e.g., z-dimension) of the SRIB 148-2, such that the SRIB 148-2 is between the bottom surface of the die 114-1, 114-2 and the second surface 170-2 of the core 103. Microelectronic assembly 100 may include a core 103 having a second surface 170-2 that is substantially planar, such that bottom surfaces of interconnects 150 are co-planar with a bottom surface of the SRIB 148-2 (e.g., the SRIB 148-2 is not nested in a cavity). In some embodiments, the interconnects 150 have a height 195 (e.g., z-dimension) between 20 microns and 60 microns. In some embodiments, interconnects 150 disclosed herein may have a pitch between about 80 microns and 150 microns.

The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). The conductive pathways in the dies 114 may be bordered by liner materials, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked). In various embodiments, die 114 may include, or be a part of, one or more of a central processing unit (CPU), a memory device (e.g., a high-bandwidth memory device), a logic circuit, input/output circuitry, a transceiver such as a field programmable gate array transceiver, a gate array logic such as a field programmable gate array logic, of a power delivery circuitry, a III-V or a III-N device such as a III-N or III-N amplifier (e.g., GaN amplifier), Peripheral Component Interconnect Express (PCIe) circuitry, Double Data Rate (DDR) transfer circuitry, or other electronic components known in the art. In some embodiments, die 114-1 and die 114-2 may include different functionalities. As used herein, the term "functionality" with reference to a die refers to one or more functions (e.g., capability, task, operation, action, instruction execution, etc.) that the die in question can perform. For example, die 114-1 may be a CPU and die 114-2 may be a Graphics Processing Unit (GPU) or memory. In other embodiments, die 114-1 and die 114-2 may include the same or similar functionalities. For example, die 114-1 and die 114-2 may each include memory. In some embodiments, die 114-1 may include a CPU die, a system-on-chip die, or a compute die, and die 114-2 may include a memory die, an input/output (I/O) die, a graphics processing unit (GPU) die, a field programmable gate array (FPGA) die, a deep learning processor (DLP) die, or a neural network processor (NNP) die.

The microelectronic assembly 100 of FIG. 1 may also include an underfill material 127. In some embodiments, the underfill material 127 may extend between die 114-1, 114-2 and the second surface 170-2 of the core 103 around the SRIB 148-2 and interconnects 150. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering die 114-1, 114-2 to the second surface 170-2 of the core 103 when forming the interconnects 150, and then polymerizes and encapsulates the interconnects 150. The underfill process may include dispensing underfill material in liquid form, allowing the material to flow and fill the interstitial gaps around interconnects 150, and subjecting the assembly to a curing process, such as baking, to solidify the material. In some embodiments, an underfill material 127 may be omitted. The underfill material 127 may be selected to have a coefficient of thermal expansion (CTE) that may mitigate or minimize the stress between the core 103, die 114, and the SRIB 148-2 arising from uneven thermal expansion in the microelectronic assembly 100.

The microelectronic assembly 100 of FIG. 1 may also include a circuit board 131. In particular, conductive contacts 172-1 on a bottom surface of the first substrate 148-1 may be electrically coupled to conductive contacts 146 on a top surface of circuit board 131 by interconnects 190. Interconnects 190 disclosed herein may take any suitable form, including solder balls for a ball grid array arrangement, pins in a pin grid array arrangement or lands in a land grid array arrangement, or any of the forms described above with reference to interconnects 140. As shown in FIG. 1, in some embodiments, a set of interconnects 190 may include solder (e.g., solder bumps or balls that are subject to a thermal reflow to form the interconnects 190). In some embodiments, the interconnects 190 disclosed herein may have a pitch between about 50 microns and 300 microns. In some embodiments, an underfill material 127 may extend between the first substrate 148-1 and the circuit board 131 around the associated interconnects 190. The circuit board 131 may be a motherboard, for example, and may have other components attached to it, such as surface-mount resistors, capacitors, and/or inductors. Any method known in the art for fabrication of the circuit board 131 may be used. When the circuit board 131 is formed using standard printed circuit board (PCB) processes, the circuit board 131 may include FR-4, and the conductive pathways in the circuit board 131 may be formed by patterned sheets of copper separated by build-up layers of the FR-4. The conductive pathways in the circuit board 131 may be bordered by liner materials, such as adhesion liners and/or barrier liners, as suitable. The circuit board may include conductive pathways and other conductive contacts for routing power, ground, and signals through the circuit board, as known in the art. In some embodiments, the interconnects 190 may not couple to a circuit board 131, but may instead couple to another IC package, an interposer, or any other suitable component.

In some embodiments, one or more levels of solder resist (e.g., epoxy liquid, liquid photoimageable dielectrics, dry film photoimageable dielectrics, acrylics, solvents) may be provided in an IC package described herein and may not be labeled or shown to avoid cluttering the drawings. Solder resist may be a liquid or dry film material including photoimageable dieletrics. In some embodiments, solder resist may be non-photoimageable.

Many of the elements of the microelectronic assembly 100 of FIG. 1 are included in other ones of the accompanying drawings; the discussion of these elements is not repeated when discussing these drawings, and any of these elements may take any of the forms disclosed herein. Further, various elements are illustrated in FIG. 1 as included in the microelectronic assembly 100, but, in various embodiments, some of these elements may not be included. For example, in various embodiments, the first substrate 148-1, the underfill material 127, and the circuit board 131 may not be present in the microelectronic assembly 100. Although FIG. 1 depicts a microelectronic assembly 100 having a particular number and arrangement of components, this is simply illustrative, and a microelectronic assembly 100 may include any desired number and arrangement of components (e.g., die 114, SRIB 148-2, TGVs 110, etc.). In some embodiments, individual ones of the microelectronic assemblies 100 disclosed herein may serve as a system-in-package (SiP) in which multiple dies 114 having different functionality are included. In such embodiments, the microelectronic assembly 100 may be referred to as an SiP.

FIG. 2 is a schematic top view of an example microelectronic assembly according to some embodiments of the present disclosure. The configuration of the embodiment shown in the figure illustrates a top surface (e.g., a second surface 170-2 as shown in FIG. 1) of a core 103 including four die 114 (e.g., die 114-1, 114-2, 114-3, 114-4) and three SRIB 148-2 (e.g., SRIB 148-2A, 148-2B, 148-2C).

The first die 114-1 may include conductive contacts 122-1A adjacent to a first side 201 (e.g., lateral surface) and conductive contacts 122-1B adjacent to a second side 202. (Note that the conductive contacts 122-1 are shown in the figure as grouped within a rectangular box or region to make the conductive contacts 122-1 more visible. In an actual microelectronic assembly, the conductive contacts 122-1 may not be contained by a rectangular box or within a particular group or designated region.) The second die 114-2 may include conductive contacts 122-1C adjacent to a third side 203 and conductive contacts 122-1D adjacent to a fourth side 204. The third die 114-3 may include conductive contacts 122-1E adjacent to a fifth side 205. The fourth die 114-4 may include conductive contacts 122-1F adjacent to a sixth side 206. Conductive pathways 196-2A in a first SRIB 148-2A may electrically couple conductive contacts 122-1A on the first die 114-1 and conductive contacts 122-1C on the second die 114-2. In particular, conductive contacts 122-1A on the first die 114-1 are at a first side 201 that face and align with conductive contacts 122-1C on the second die 114-2 at a third side 203, such that the conductive pathways 196-2A in the first SRIB 148-2A may include Manhattan (e.g., straight and orthogonal) routing. Conductive pathways 196-2B in a second SRIB 148-2B may electrically couple conductive contacts 122-1B on the first die 114-1 and conductive contacts 122-1E on the third die 114-3. In particular, conductive contacts 122-1B on the first die 114-1 are at a second side 202 that face, but do not align, with conductive contacts 122-1E on the third die 114-3 at a fifth side 205, such that the conductive pathways 196-2B in the second SRIB 148-2B may include non-Manhattan (e.g., diagonal) routing. Conductive pathways 196-2C in a third SRIB 148-2C may electrically couple conductive contacts 122-1D on the second die 114-2 and conductive contacts 122-1F on the fourth die 114-4. In particular, conductive contacts 122-1D on the second die 114-2 are at a fourth side 204 that does not face conductive contacts 122-1F on the fourth die 114-4 at a sixth side 206, such that the conductive pathways 196-2C in the third SRIB 148-2C may include non-Manhattan (e.g., curvilinear) routing.

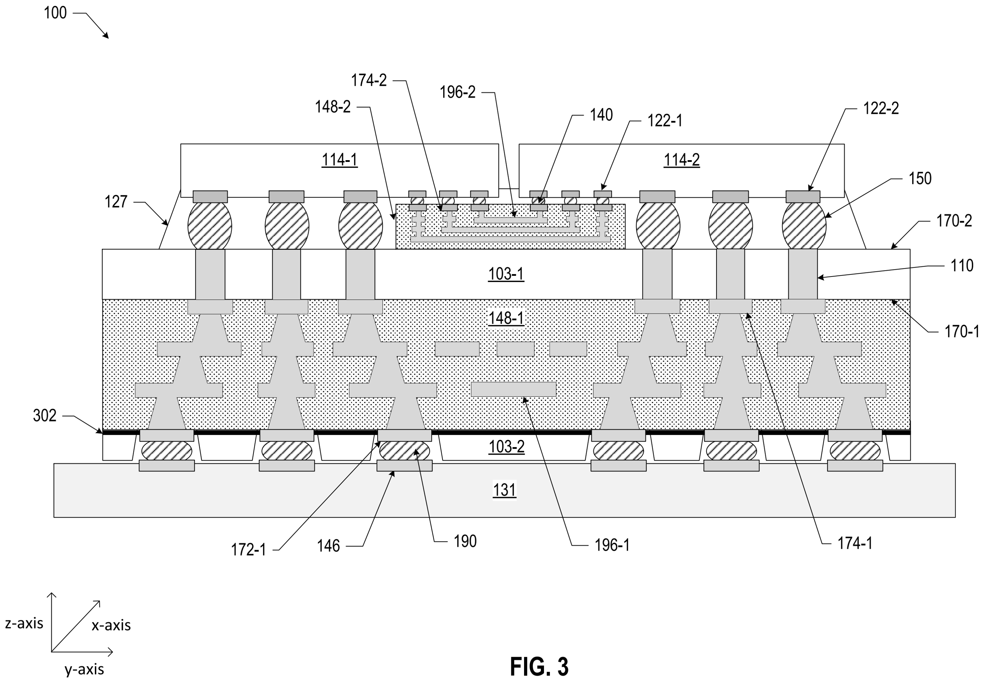

FIG. 3 shows a simplified schematic side, cross-sectional view of another example microelectronic assembly according to some embodiments of the present disclosure. The configuration of the embodiment shown in the figure is like that of FIG. 1, except for differences as described further. In particular, FIG. 3 illustrates an embodiment including a first core 103-1 and further including a second core 103-2 attached to a bottom surface of the first substrate 148-1. The second core 103-2 may provide additional mechanical support and stability to the microelectronic assembly 100 and may function to reduce warpage. The second core 103-2 may be formed of any suitable material, including a bulk glass, silicon, an organic dielectric, or a ceramic. The second core 103-2 may have a thickness between 50 microns and 700 microns. In some embodiments, a thickness of the second core 103-2 is the same as a thickness of the first core 103-1. In some embodiments, a thickness of the second core 103-2 is greater than a thickness of the first core 103-1. In some embodiments, a thickness of the second core 103-2 is less than a thickness of the first core 103-1. The second core 103-2 may be attached to the bottom surface of the first substrate 148-1 using any suitable technique, such as an adhesive 302.

FIG. 4 shows a simplified schematic side, cross-sectional view of another example microelectronic assembly according to some embodiments of the present disclosure. The configuration of the embodiment shown in the figure is like that of FIG. 1, except for differences as described further. FIG. 4 illustrates an embodiment illustrating a power delivery network (PDN) where the assembly further includes an SRIB 148-2 having conductive contacts 172-2 at a bottom surface electrically coupled to TGVs 110 in the core 103. In particular, the PDN includes conductive pathways 196-1B, 196-2B of the respective first substrate 148-1 and the SRIB 148-2 and TGV 110B coupled to a ground or zero voltage connection point (e.g., also referred to herein as "Vss") (e.g., as indicated in the figure by the darkest shading), conductive pathways 196-1C, 196-2C of the respective first substrate 148-1 and the SRIB 148-2 and TGV 110C coupled to a first positive power supply voltage (e.g., also referred to herein as a "first Vcc"), and conductive pathways 196-1D, 196-2D of the respective first substrate 148-1 and the SRIB 148-2 and TGV 110D coupled to a second positive power supply voltage (e.g., also referred to herein as a "second Vcc") (e.g., the first Vcc and second Vcc are indicated in the figure by the medium shading). Conductive pathways 196-1A, 196-2A of the respective first substrate 148-1 and the SRIB 148-2 and TGV 110A are signal paths (e.g., as indicated in the figure by the lightest shading).

As shown in FIG. 4, the microelectronic assembly 100 further includes microstrip routing. In particular, the conductive pathways 196-1 in the first substrate 148-1 include a first metallization layer 424 on a second metallization layer 426. The first metallization layer 424 is at the first surface 170-1 of the core 103 and includes signal traces. The second metallization layer 426 includes a first Vss plane (i.e., a first ground plane). The microelectronic assembly 100 further includes a dielectric layer 433 on the second surface 170-2 of the core 103, the dielectric layer 433 having a third metallization layer 428 that includes a second Vss plane (i.e., a second ground plane). The microstrip routing of the microelectronic assembly 100 may reduce a thickness (e.g., z-dimension) of the first substrate 148-1 by removing a metallization layer (e.g., a third metallization layer 428) and adding the third metallization layer 428 to the second surface 170-2 of the core 103 and within a height (e.g., height 195 as shown in FIG. 1) of interconnects 150. A material of the dielectric layer 433 may include an organic dielectric material, such as an organic buildup film, a polyimide, a polyamide, a polyacrylate, an epoxy, a polybenzoxazole, a polyphenyl ether, a polysiloxane, a polynorbornene, or a polyolefin. In some embodiments, a material of the dielectric layer 433 may include a solder resist. The circuit board 131 may further include a power source 435 and other components necessary for the PDN, such as a voltage regulator and/or decoupling capacitors (not shown). The PDN conductive pathways 196-1B, 196-1C, 196-1D may be electrically coupled to the power source 435 and other power delivery components in the circuit board 131 by interconnects 190. The microelectronic assembly 100 may provide for improved power delivery through the PDN due to lower electrical resistance and increased thermal interface.

Any suitable techniques may be used to manufacture the microelectronic assemblies 100 disclosed herein. For example, FIGS. 5A-5H are side, cross-sectional views of various stages in an example process for manufacturing the microelectronic assembly 100 of FIG. 1, in accordance with various embodiments. Although the operations discussed below with reference to FIGS. 5A-5H (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 5A-5H may be modified in accordance with the present disclosure to fabricate others of microelectronic assembly 100 disclosed herein.

FIG. 5A illustrates an assembly including a first core 103A having a first surface 170-1A and an opposing second surface 170-2A, and a second core 103B having a first surface 170-1B and an opposing second surface 170-2B, where the first surfaces 170-1A, 170-1B of the respective first core 103A and second core 103B are removably coupled together by an adhesive 502 or other similar technique. The cores 103A, 103B may have any suitable dimensions, for example, the cores 103A, 103B may include a full panel having a surface area of approximately 500 millimeters by 500 millimeters (e.g., xy-dimension), or may include a quarter panel having a surface area of approximately 250 millimeters by 250 millimeters. In some embodiments, a core 103 may have a surface area of between approximately 10 millimeters by 10 millimeters and approximately 240 millimeters by 240 millimeters.

FIG. 5B illustrates an assembly subsequent to forming TGV openings 511 through the cores 103A, 103B extending between the respective first surfaces 170-1A, 170-1B and second surfaces 170-2A, 170-2B of the cores 103A, 103B. Although six TGV openings 511 are shown in FIG. 5B as well as in FIGS. 5C-5H, in other embodiments, the microelectronic assemblies described herein may include any number of one or more TGV openings 511. In various embodiments, the TGV openings 511 may be formed using any suitable subtractive technique such as direct laser drilling or laser-induced etching process, possibly in combination with any suitable patterning technique such as photolithographic or electron-beam (e-beam) patterning. In other embodiments, the TGV openings 511 may be formed during fabrication of a glass core itself, e.g., when molten glass is filled into a mold that has space for the future TGV openings 511.

FIG. 5C illustrates an assembly subsequent to depositing a conductive material in the TGV openings 511 to form TGVs 110. The conductive material of the TGVs 110 may include any suitable conductive material, e.g., any of the materials described above with reference to FIG. 1. The conductive material may include any suitable metal, such as copper, and may be deposited using any suitable technique, such as electroplating, or a solder paste printing process.

FIG. 5D illustrates an assembly subsequent to forming an SRIB 148-2A on the second surface 170-2A of the first core 103A and an SRIB 148-2B on the second surface 170-2B of the second core 103B. The SRIBs 148-2A, 148-2B may include respective conductive pathways 196-2A, 196-2B coupling respective conductive contacts 174-2A, 174-2B. The SRIBs 148-2A, 148-2B may be formed directly on the respective second surfaces 170-2A, 170-2B of the cores 103A, 103B using any suitable technique, such as a redistribution process or a photolithography process.

FIG. 5E illustrates first and second assemblies subsequent to detaching the first core 103A from the second core 103B by removing the adhesive 502 and inverting the second assembly.

FIG. 5F illustrates a single assembly of FIG. 5E subsequent to attaching a protective carrier 504 on the second surface 170-2 of the core 103 that surrounds the SRIB 148-2, inverting the assembly, and forming a first substrate 148-1 on the first surface 170-1 of the core 103. The carrier 504 may include any suitable material for providing mechanical stability and protection during manufacturing operations, such as a metal carrier, a glass carrier, or a silicon carrier. The first substrate 148-1 may include conductive pathways 196-1 (e.g., multiple metallization layers connected by vias through a dielectric material) coupling conductive contacts 172-1, 174-1. The first substrate 148-1 may be manufactured using any suitable process, as described above with reference to FIG. 1, including, for example, conventional package substrate manufacturing techniques (e.g., lamination of layers of the dielectric material, etc.).

FIG. 5G illustrates an assembly subsequent to inverting the assembly of FIG. 5E, removing the carrier 504, and aligning die 114-1, 114-2 having solder 532, 534 on respective conductive contacts 122-1, 122-2 with the SRIB 148-2 contacts 174-2 and the TGVs 110 at the second surface 170-2 of the core 103. The die 114-1, 114-2 may include solder 532, 534 on respective conductive contacts 122-1, 122-2. The die 114-1 may be placed using any suitable technique, for example, automated pick and place tooling.

FIG. 5H illustrates an assembly subsequent to electrically coupling die 114-1, 114-2 to the SRIB 148-2 by forming interconnects 140 and to the TGVs 110 in the core 103 by forming interconnects 150, and dispensing an underfill material 127 between die 114-1, 114-2 and the second surface 170-2 of the core 103 around the SRIB 148-2, interconnects 140, and interconnects 150. Interconnects 140, 150 may include solder, such that the assembly may be subjected to a thermal reflow to form interconnects 140, 150. The assembly of FIG. 5H may itself be a microelectronic assembly 100, as shown. Further manufacturing operations may be performed on the microelectronic assembly 100 of FIG. 5H to form other microelectronic assembly 100; for example, depositing solder on a bottom surface of conductive contacts 172-1, attaching a circuit board 131 to a bottom surface of the microelectronic assembly 100 of FIG. 5H by forming interconnects 190, similar to FIG. 1. If multiple assemblies are manufactured together, the assemblies may be singulated.

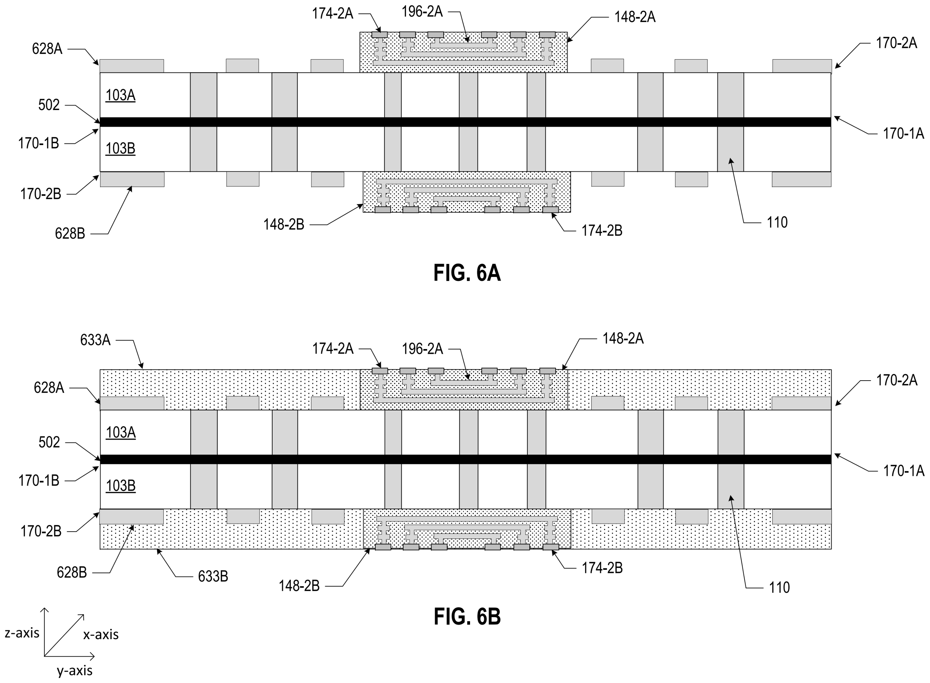

FIG. 6A illustrates an assembly similar to the assembly of FIG. 5D and further including a third metallization layer 628A, 628B (e.g., similar to the third metallization layer 428 of FIG. 4) on respective second surfaces 170-2A, 170-2B of the first and second cores 103A, 103B. The third metallization layer 628A, 628B may be formed using any suitable technique, including dry film resist (DFR) lamination/etching/electroplating or a metal printing process, and may include any suitable conductive material, such as copper.

FIG. 6B illustrates an assembly subsequent to forming a dielectric layer 633A, 633B (e.g., similar to the dielectric layer 433 of FIG. 4) on and over the respective third metallization layer 628A, 628B on respective second surfaces 170-2A, 170-2B of the first and second cores 103A, 103B. The dielectric layer 633A, 633B may be formed using any suitable technique, including a hot press lamination process. A surface of the dielectric layer 633A, 633B may be planarized using chemical mechanical polishing (CMP) or any other suitable process to expose conductive contacts 174-2A, 174-2B at the surface of the respective SRIB 148-2A, 148-2B.

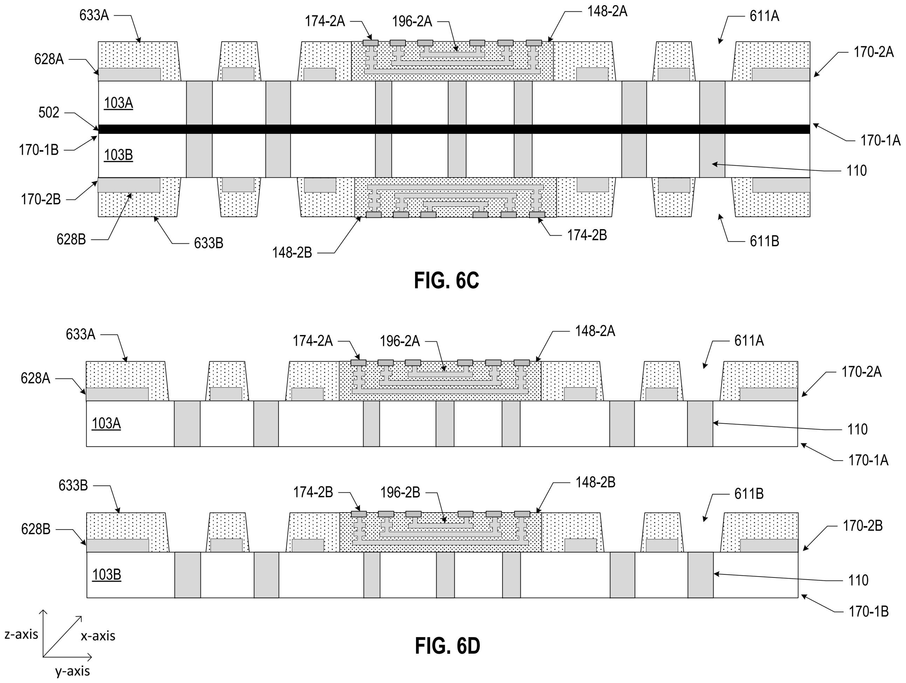

FIG. 6C illustrates an assembly subsequent to forming openings 611A, 611B in the respective dielectric layers 633A, 633B to expose TGVs 110 in the cores 103A, 103B. The openings 611A, 611B, may be formed using any suitable technique, such as laser drilling/chemical etching process.

FIG. 6D illustrates first and second assemblies subsequent to detaching the first core 103A from the second core 103B by removing the adhesive 502 and inverting the second assembly. Further manufacturing operations may be performed on the first and second assemblies of FIG. 6D, including operations described above with reference to FIGS. 5F-5H, to form other microelectronic assembly 100, such as a microelectronic assembly 100 similar to FIG. 4.

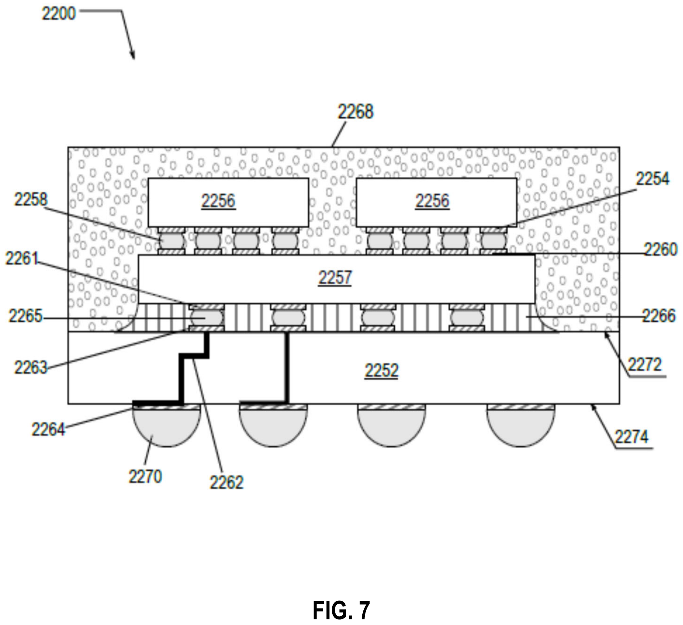

The packages disclosed herein, e.g., any of the microelectronic assemblies 100, or any further embodiments described herein, may be included in any suitable electronic component. FIGS. 7-9 illustrate various examples of packages, assemblies, and devices that may be used with or include any of the IC packages as disclosed herein.

FIG. 7 is a side, cross-sectional view of an example IC package 2200 that may include microelectronic assemblies in accordance with any of the embodiments disclosed herein. In some embodiments, the IC package 2200 may be a system-in-package (SiP).

As shown in FIG. 7, package support 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures including lines and/or vias, e.g., as discussed above with reference to FIG. 1.

Package support 2252 may include conductive contacts 2263 that are coupled to conductive pathway 2262 through package support 2252, allowing circuitry within dies 2256 and/or interposer 2257 to electrically couple to various ones of conductive contacts 2264 (or to other devices included in package support 2252, not shown).

IC package 2200 may include interposer 2257 coupled to package support 2252 via conductive contacts 2261 of interposer 2257, first level interconnects (FLI) 2265, and conductive contacts 2263 of package support 2252. FLI 2265 illustrated in FIG. 7 are solder bumps, but any suitable FLI 2265 may be used, such as solder bumps, solder posts, or bond wires.

IC package 2200 may include one or more dies 2256 coupled to interposer 2257 via conductive contacts 2254 of dies 2256, FLI 2258, and conductive contacts 2260 of interposer 2257. In various embodiments, interposer 2257 may include core 103 including glass as described herein. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). FLI 2258 illustrated in FIG. 7 are solder bumps, but any suitable FLI 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

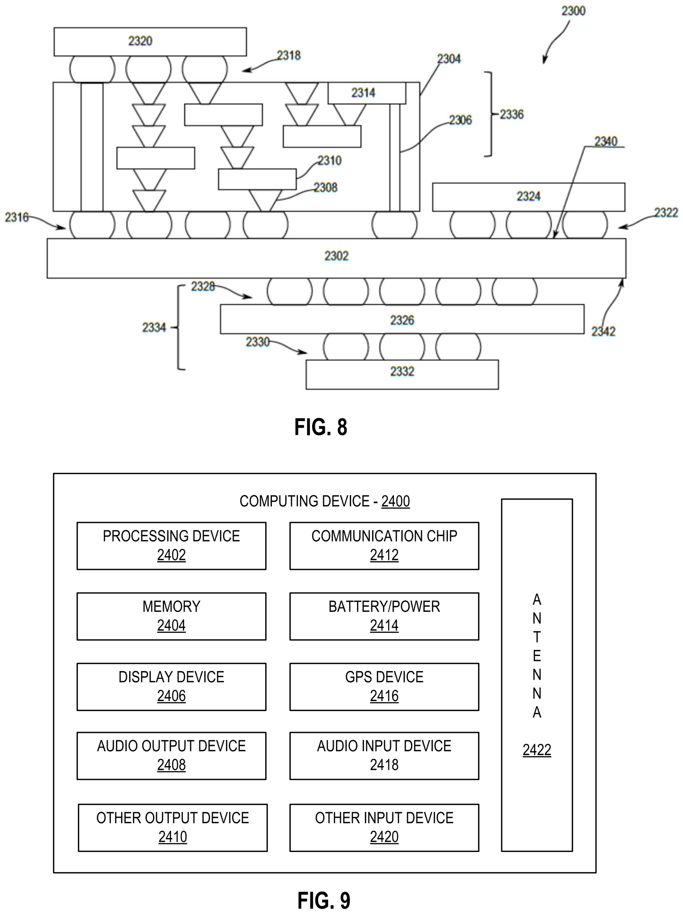

In some embodiments, underfill material 2266 may be disposed between package support 2252 and interposer 2257 around FLI 2265, and mold 2268 may be disposed around dies 2256 and interposer 2257 and in contact with package support 2252. In some embodiments, underfill material 2266 may be the same as mold 2268. Example materials that may be used for underfill material 2266 and mold 2268 are epoxies as suitable. Second level interconnects (SLI) 2270 may be coupled to conductive contacts 2264. SLI 2270 illustrated in FIG. 7 are solder balls (e.g., for a ball grid array (BGA) arrangement), but any suitable SLI 2270 may be used (e.g., pins in a pin grid array arrangement or lands in a land grid array arrangement). SLI 2270 may be used to couple IC package 2200 to another component, such as a circuit board (e.g., a motherboard), an interposer, or another IC package, as known in the art and as discussed below with reference to FIG. 9.

In embodiments in which IC package 2200 includes multiple dies 2256, IC package 2200 may be referred to as a multichip package (MCP). Dies 2256 may include circuitry to perform any desired functionality. For example, besides one or more of dies 2256 including components of dies 114 as described herein, one or more of dies 2256 may be logic dies (e.g., silicon-based dies), one or more of dies 2256 may be memory dies (e.g., high-bandwidth memory), etc. In some embodiments, at least some of dies 2256 may not include components of dies 114 as described herein.

Although IC package 2200 illustrated in FIG. 7 is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package support 2252, or on either face of interposer 2257. More generally, IC package 2200 may include any other active or passive components known in the art.

FIG. 8 is a cross-sectional side view of an IC device assembly 2300 that may include components having one or more microelectronic assembly 100 in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; e.g., any of the IC packages discussed below with reference to IC device assembly 2300 may take the form of any of the embodiments of IC package 2200 discussed above with reference to FIG. 7.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package support.

FIG. 8 illustrates that, in some embodiments, IC device assembly 2300 may include a package-on-interposer structure 2336 coupled to first face 2340 of circuit board 2302 by coupling components 2316. Although not shown so as not to clutter the drawing, package-on-interposer structure 2336 may include a core 103, such as glass layer, in some embodiments. In other embodiments, package-on-interposer structure 2336 may not include a core. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. In some embodiments, IC package 2320 may include microelectronic assembly 100, and other components as described herein, which are not shown so as not to clutter the drawing. Coupling components 2318 may take any suitable form depending on desired functionalities, such as the forms discussed above with reference to coupling components 2316. In some embodiments, IC package 2320 may be or include IC package 2200, e.g., as described above with reference to FIG. 7.

Although a single IC package 2320 is shown in FIG. 8, multiple IC packages may be coupled to interposer 2304; indeed, additional interposers may be coupled to interposer 2304. Interposer 2304 may provide an intervening package support used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in FIG. 8, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2310 and vias 2308, including TSVs 2306. Interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 9 is a block diagram of an example computing device 2400 that may include one or more components having one or more IC packages in accordance with any of the embodiments disclosed herein. For example, any suitable ones of the components of computing device 2400 may include microelectronic assembly 100 including glass in accordance with any of the embodiments disclosed herein. In another example, any one or more of the components of computing device 2400 may include any embodiments of IC package 2200 (e.g., as shown in FIG. 7). In yet another example, any one or more of the components of computing device 2400 may include an IC device assembly 2300 (e.g., as shown in FIG. 8).

A number of components are illustrated in FIG. 9 as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single SOC die.

Additionally, in various embodiments, computing device 2400 may not include one or more of the components illustrated in FIG. 9, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more digital signal processors (DSPs), ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips; note that the terms "chip," "die," and "IC die" are used interchangeably herein). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives of it, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

The above description of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

The following paragraphs provide various examples of the embodiments disclosed herein.

Example 1 provides a microelectronic assembly, including a core including conductive vias extending between a first surface and an opposing second surface of the core, where the second surface of the core is planar; a substrate on the second surface of the core, the substrate including a third surface and an opposing fourth surface, where the third surface of the substrate is in contact with the second surface of the core, and the fourth surface of the substrate includes conductive contacts; and a die at the second surface of the core, partially overlapping the substrate, the die including first conductive contacts electrically coupled to some of the conductive contacts of the substrate and second conductive contacts electrically coupled to some of the conductive vias in the core.

Example 2 provides the microelectronic assembly of example 1, where a thickness of the substrate is between 10 microns and 50 microns.

Example 3 provides the microelectronic assembly of example 1 or 2, where the substrate includes conductive pathways through a dielectric material and the conductive pathways have non-Manhattan routing.

Example 4 provides the microelectronic assembly of any one of examples 1-3, where a material of the core includes a bulk glass, silicon, an organic dielectric, or a ceramic.

Example 5 provides the microelectronic assembly of any one of examples 1-4, where a thickness of the core is between 50 microns and 700 microns.

Example 6 provides the microelectronic assembly of any one of examples 1-5, where the die is a first die, and the microelectronic assembly further including a second die at the second surface of the core, partially overlapping the substrate, the second die including third conductive contacts electrically coupled to some of the conductive contacts of the substrate and fourth conductive contacts electrically coupled to some of the conductive vias in the core.

Example 7 provides the microelectronic assembly of example 6, where the first die is electrically coupled to the second die by conductive pathways in the substrate.

Example 8 provides the microelectronic assembly of example 6 or 7, where first conductive contacts of the first die are adjacent to a first side of the first die, the third conductive contacts of the second die are adjacent to a second side of the second die, and the first side of the first die faces the second side of the second die.

Example 9 provides the microelectronic assembly of any one of examples 6-8, where first conductive contacts of the first die are adjacent to a first side of the first die, the third conductive contacts of the second die are adjacent to a second side of the second die, and the first side of the first die does not face the second side of the second die.

Example 10 provides the microelectronic assembly of any one of examples 6-9, where the first die includes a central processing (CPU) die, a system-on-chip die, or a compute die.

Example 11 provides the microelectronic assembly of any one of examples 6-10, where the second die includes a memory die, an input/output (I/O) die, a graphics processing unit (GPU) die, a field programmable gate array (FPGA) die, a deep learning processor (DLP) die, or a neural network processor (NNP) die.

Example 12 provides the microelectronic assembly of any one of examples 1-11, where the substrate is a second substrate, and the microelectronic assembly further including a first substrate on the first surface of the core, the first substrate including a fifth surface having fifth conductive contacts and a sixth surface opposite the fifth surface having sixth conductive contacts electrically coupled to one or more of the conductive vias.

Example 13 provides the microelectronic assembly of example 12, further including a second core coupled to the fifth surface of the first substrate.

Example 14 provides the microelectronic assembly of example 12 or 13, further including a circuit board at the fifth surface of the first substrate and electrically coupled to the fifth conductive contacts.

Example 15 provides a microelectronic assembly, including a glass layer having a first surface and an opposing second surface, where the second surface is planar and has a first surface area; through-glass vias (TGVs) extending through the glass layer between the first surface and the second surface, the TGVs including a conductive material; a first substrate on the first surface of the glass layer, the first substrate including first conductive pathways through a first dielectric material electrically coupled to one or more of the TGVs; a second substrate on and in contact with the second surface of the glass layer, the second substrate including second conductive pathways through a second dielectric material and having a second surface area less than the first surface area; a first die at the second surface of the glass layer, where the first die partially overlaps the second substrate, is electrically coupled to the second conductive pathways in the second substrate by first interconnects, and is electrically coupled to one or more of the TGVs by second interconnects; and a second die at the second surface of the glass layer, where the second die partially overlaps the second substrate, is electrically coupled to the second conductive pathways in the second substrate by third interconnects, and is electrically coupled to one or more of the TGVs by fourth interconnects.

Example 16 provides the microelectronic assembly of example 15, where the second conductive pathways have non-Manhattan routing.

Example 17 provides the microelectronic assembly of example 15 or 16, where a thickness of the second substrate is between 10 microns and 50 microns.

Example 18 provides the microelectronic assembly of any one of examples 15-17, where the second interconnects and the fourth interconnects include solder.

Example 19 provides the microelectronic assembly of any one of examples 15-18, where a height of the second interconnects and the fourth interconnects is between 20 microns and 60 microns.

Example 20 provides the microelectronic assembly of any one of examples 15-19, where the first interconnects and the third interconnects have a pitch between 10 microns and 50 microns.

Example 21 provides the microelectronic assembly of any one of examples 15-20, where the second interconnects and the fourth interconnects have a pitch between 80 microns and 150 microns.

Example 22 provides the microelectronic assembly of any one of examples 15-21, where the first conductive pathways have a line width/spacing between 9µm/12µm and 14µm/20µm.

Example 23 provides the microelectronic assembly of any one of examples 15-22, where the second conductive pathways have a line width/spacing between 1µm/1µm and 5µm/5µm.

Example 24 provides the microelectronic assembly of any one of examples 15-23, where the first die includes a central processing (CPU) die, a system-on-chip die, or a compute die.

Example 25 provides the microelectronic assembly of any one of examples 15-24, where the second die includes a memory die, an input/output (I/O) die, a graphics processing unit (GPU) die, a field programmable gate array (FPGA) die, a deep learning processor (DLP) die, or a neural network processor (NNP) die.

Example 26 provides the microelectronic assembly of any one of examples 15-25, where the glass layer is a first glass layer, and the microelectronic assembly further including a second glass layer coupled to the first substrate at a surface opposite the first glass layer.

Example 27 provides the microelectronic assembly of example 26, where the second glass layer is coupled to the first substrate by an adhesive.

Example 28 provides the microelectronic assembly of any one of examples 15-27, further including a circuit board electrically coupled to the first conductive pathways in the first substrate, where the circuit board is at a surface opposite the glass layer.

Example 29 provides a microelectronic assembly, including a core having a first surface and an opposing second surface, where the second surface is planar and has a first surface area; through-glass vias (TGVs) extending through the core between the first surface and the second surface, the TGVs including a conductive material; a first substrate on the first surface of the core, the first substrate including a third surface and an opposing fourth surface at the first surface of the core, and first conductive pathways through a first dielectric material electrically coupled to one or more of the TGVs, the first conductive pathways including a first metallization layer on a second metallization layer, where the first metallization layer is at the fourth surface of the first substrate and includes an electrical signal layer, and the second metallization layer includes a first ground plane layer; a second substrate on and in contact with the second surface of the core, the second substrate having a second surface area that is less than the first surface area and including second conductive pathways through a second dielectric material electrically coupled to one or more of the TGVs; a dielectric layer having a third metallization layer on the second surface of the core around the second substrate, the third metallization layer including a second ground plane layer; and a die at the second surface of the core, where the die partially overlaps the second substrate, is electrically coupled to the second conductive pathways in the second substrate, and is electrically coupled to one or more of the TGVs.

Example 30 provides the microelectronic assembly of example 29, where the second conductive pathways have non-Manhattan routing.

Example 31 provides the microelectronic assembly of example 29 or 30, where a thickness of the second substrate is between 10 microns and 50 microns.

Example 32 provides the microelectronic assembly of any one of examples 29-31, where a material of the core includes a bulk glass, silicon, organic dielectric, or a ceramic.

Example 33 provides the microelectronic assembly of any one of examples 29-32, where a thickness of the core is between 50 microns and 700 microns.

Example 34 provides the microelectronic assembly of any one of examples 29-33, further including a circuit board electrically coupled to the first conductive pathways in the first substrate, where the circuit board is at a surface opposite the core.

## Claims

1. A microelectronic assembly, comprising:
a core including conductive vias extending between a first surface and an opposing second surface of the core, wherein the second surface of the core is planar;
a substrate on the second surface of the core, the substrate including a third surface and an opposing fourth surface, wherein the third surface of the substrate is in contact with the second surface of the core, and the fourth surface of the substrate includes conductive contacts; and
a die at the second surface of the core, partially overlapping the substrate, the die including first conductive contacts electrically coupled to some of the conductive contacts of the substrate and second conductive contacts electrically coupled to some of the conductive vias in the core.

2. The microelectronic assembly of claim 1, wherein a thickness of the substrate is between 10 microns and 50 microns.

3. The microelectronic assembly of claim 1 or 2, wherein the substrate includes conductive pathways through a dielectric material and the conductive pathways have non-Manhattan routing.

4. The microelectronic assembly of any one of claims 1-3, wherein a material of the core includes a bulk glass, silicon, an organic dielectric, or a ceramic.

5. The microelectronic assembly of any one of claims 1-4, wherein the die is a first die, and the microelectronic assembly further comprising:
a second die at the second surface of the core, partially overlapping the substrate, the second die including third conductive contacts electrically coupled to some of the conductive contacts of the substrate and fourth conductive contacts electrically coupled to some of the conductive vias in the core.

6. The microelectronic assembly of claim 5, wherein the first die is electrically coupled to the second die by conductive pathways in the substrate.

7. The microelectronic assembly of claim 5, wherein first conductive contacts of the first die are adjacent to a first side of the first die, the third conductive contacts of the second die are adjacent to a second side of the second die, and the first side of the first die faces the second side of the second die.

8. The microelectronic assembly of claim 5, wherein first conductive contacts of the first die are adjacent to a first side of the first die, the third conductive contacts of the second die are adjacent to a second side of the second die, and the first side of the first die does not face the second side of the second die.

9. The microelectronic assembly of any one of claims 1-8, wherein the substrate is a second substrate, and the microelectronic assembly further comprising:
a first substrate on the first surface of the core, the first substrate including a fifth surface having fifth conductive contacts and a sixth surface opposite the fifth surface having sixth conductive contacts electrically coupled to one or more of the conductive vias.

10. The microelectronic assembly of claim 9, further comprising:
a second core coupled to the fifth surface of the first substrate.

11. A microelectronic assembly, comprising:
a glass layer having a first surface and an opposing second surface, wherein the second surface is planar and has a first surface area;
through-glass vias (TGVs) extending through the glass layer between the first surface and the second surface, the TGVs including a conductive material;
a first substrate on the first surface of the glass layer, the first substrate including first conductive pathways through a first dielectric material electrically coupled to one or more of the TGVs;
a second substrate on and in contact with the second surface of the glass layer, the second substrate including second conductive pathways through a second dielectric material and having a second surface area less than the first surface area;
a first die at the second surface of the glass layer, wherein the first die partially overlaps the second substrate, is electrically coupled to the second conductive pathways in the second substrate by first interconnects, and is electrically coupled to one or more of the TGVs by second interconnects; and
a second die at the second surface of the glass layer, wherein the second die partially overlaps the second substrate, is electrically coupled to the second conductive pathways in the second substrate by third interconnects, and is electrically coupled to one or more of the TGVs by fourth interconnects.

12. The microelectronic assembly of claim 11, wherein the second conductive pathways have a line width/spacing between 1µm/1µm and 5µm/5µm.

13. A microelectronic assembly, comprising:
a core having a first surface and an opposing second surface, wherein the second surface is planar and has a first surface area;
through-glass vias (TGVs) extending through the core between the first surface and the second surface, the TGVs including a conductive material;
a first substrate on the first surface of the core, the first substrate including a third surface and an opposing fourth surface at the first surface of the core, and first conductive pathways through a first dielectric material electrically coupled to one or more of the TGVs, the first conductive pathways including a first metallization layer on a second metallization layer, wherein:
the first metallization layer is at the fourth surface of the first substrate and includes an electrical signal layer, and
the second metallization layer includes a first ground plane layer;
a second substrate on and in contact with the second surface of the core, the second substrate having a second surface area that is less than the first surface area and including second conductive pathways through a second dielectric material electrically coupled to one or more of the TGVs;
a dielectric layer having a third metallization layer on the second surface of the core around the second substrate, the third metallization layer including a second ground plane layer; and
a die at the second surface of the core, wherein the die partially overlaps the second substrate, is electrically coupled to the second conductive pathways in the second substrate, and is electrically coupled to one or more of the TGVs.

14. The microelectronic assembly of any one of claims 11-13, wherein the second conductive pathways have non-Manhattan routing.

15. The microelectronic assembly of any one of claims 11-14, wherein a thickness of the second substrate is between 10 microns and 50 microns.
